# EUROPEAN PATENT APPLICATION

(11) **EP 1 935 630 A1**
(43) Date of publication of application: **25.06.2008**
(21) Application number: 07251045.6
(22) Date of filing: 14.03.2007
(51) Int. Cl.: B32B 1/08, B32B 7/02, F16L 11/04, F28D 5/00

(54) **Flexible low permeability hose**

(30) Priority: 21.12.2006 US 614577
(71) Applicant: Isothermal Systems Research, Inc., Liberty Lake, WA 99019 (US)
(72) Inventor: Maehren, Angela R., Pullman, WA 99163 (US); Petrie, Alan R., Liberty Lake, WA 99019 (US)
(74) Representative: Style, Kelda Camilla Karen

(57) **Abstract**

A flexible low permeability hose (10) for providing an impermeable length of tube to transfer fluids that is flexible. The flexible low permeability hose (10) generally includes a first layer (20) and a second layer (40) surrounding the first layer (20), wherein a first adhesive (30) secures the second layer (40) to the first layer (20). The first layer (20) is comprised of a material not adversely affected by coolants (e.g. perfluorocarbon fluids) such as but not limited to polyethylene. The second layer (40) is comprised of a material that is impermeable to coolants and gases (e.g. ether based or ester based polyurethane material) to prevent the escape of the coolant from the hose and to prevent the entry of air into the coolant through permeation. An additional third layer (60) may be secured about the second layer (40) with a second adhesive (50) to provide protection to the second layer (e.g. fire protection, fluid exposure).

## Description

### BACKGROUND OF THE INVENTION

### Field of the Invention

The present invention relates generally to fluid transfer tubes and more specifically it relates to a flexible low permeability hose for providing a length of tube to transfer fluids that is flexible.

### Description of the Related Art

Any discussion of the prior art throughout the specification should in no way be considered as an admission that such prior art is widely known or forms part of common general knowledge in the field.

Single layer tubing and multi-layered tubing (e.g. hydraulic hose) have been in use for years. The main purpose of multi-layered tubing is typically to provide a flexible interior material (e.g. rubber) surrounded by a protective exterior material for abrasion resistance (e.g. multiple layers of woven wire and rubber).

Tubing is used to transport various types of fluids (e.g. liquid coolant, vaporized coolant, combination of liquid and vaporized coolant) from one location to another location. For example, in a spray cooling liquid thermal management system tubing may be utilized to transport liquid coolant from and to a spray module or other devices within the spray cooling liquid thermal management system.

Single-phase liquid thermal management systems (e.g. liquid cold plates) and two-phase liquid thermal management systems (e.g. spray cooling, pool boiling, flow boiling, jet impingement cooling, falling-film cooling, parallel forced convection, curved channel cooling and capillary pumped loops) have been in use for years for thermally managing various types of heat producing devices. Spray cooling technology is being adopted today as the most efficient option for thermally managing electronic systems. United States Patent No. 5,220,804 entitled High Heat Flux Evaporative Spray Cooling to Tilton et al. describes the earlier versions of spray technology, as it relates to cooling electronics. United States Patent No. 6,108,201 entitled Fluid Control Apparatus and Method for Spray Cooling to Tilton et al. also describes the usage of spray technology to cool a printed circuit board.

The problem with conventional hose technology, particularly for liquid thermal management systems, is that the hose often times results in a percentage of the coolant (e.g. perfluorocarbon fluids) permeating through the hose resulting in a loss of the coolant. Another problem is that external air and moisture are able to permeate the coolant being transferred within the hose thereby contaminating the coolant.

Hence, there is a need for a hose that is flexible, resistant to various types of coolants, and impermeable to various types of coolants and gases.

### BRIEF SUMMARY OF THE INVENTION

The general purpose of the present invention is to provide a flexible low permeability hose that has many of the advantages of the fluid transfer tubes mentioned heretofore. The invention generally relates to a fluid transfer tubes which includes a first layer and a second layer surrounding the first layer, wherein a first adhesive secures the second layer to the first layer. The first layer is comprised of a material not adversely affected by coolants (e.g. perfluorocarbon fluids) such as but not limited to polyethylene. The second layer is comprised of a material that is impermeable to coolants and gases (e.g. polyurethane material - ether based or ester based, or ethyl vinyl alcohol copolymer, a.k.a. EVOH) to prevent the escape of the coolant from the hose and to prevent the entry of air or water into the coolant through permeation. An additional third layer may be secured about the second layer with a second adhesive to provide protection to the second layer (e.g. fire protection, fluid exposure).

There has thus been outlined, rather broadly, some of the features of the invention in order that the detailed description thereof may be better understood, and in order that the present contribution to the art may be better appreciated. There are additional features of the invention that will be described hereinafter and that will form the subject matter of the claims appended hereto.

In this respect, before explaining at least one embodiment of the invention in detail, it is to be understood that the invention is not limited in its application to the details of construction or to the arrangements of the components set forth in the following description or illustrated in the drawings. The invention is capable of other embodiments and of being practiced and carried out in various ways. Also, it is to be understood that the phraseology and terminology employed herein are for the purpose of the description and should not be regarded as limiting.

An object is to provide a flexible low permeability hose for providing an impermeable length of tube to transfer fluids that is flexible.

A further object is to provide a flexible low permeability hose that is both flexible and impermeable to fluids such as but not limited to air, gases, liquids and the like.

Another object is to provide a flexible low permeability hose that may be utilized to transfer various types of fluids including but not limited to perfluorocarbon fluids (e.g. FLUORINERT manufactured by 3M).

An additional object is to provide a flexible low permeability hose that may be utilized in various types of fluid transfer systems such as but not limited to single phase liquid thermal management systems and multi-phase liquid thermal management systems.

Another object is to provide a flexible low permeability hose that prevents the external air from permeating into the fluid being transferred.

Other objects and advantages of the present invention will become obvious to the reader and it is intended that these objects and advantages are within the scope of the present invention. To the accomplishment of the above and related objects, this invention may be embodied in the form illustrated in the accompanying drawings, attention being called to the fact, however, that the drawings are illustrative only, and that changes may be made in the specific construction illustrated and described within the scope of the appended claims.

### BRIEF DESCRIPTION OF THE DRAWINGS

Various other objects, features and attendant advantages of the present invention will become fully appreciated as the same becomes better understood when considered in conjunction with the accompanying drawings, in which like reference characters designate the same or similar parts throughout the several views, and wherein:
FIG. 1 is an upper perspective view of the present invention.
FIG. 2 is a magnified upper perspective view of the end of the present invention.
FIG. 3 is a cross sectional view taken along line 3-3 of Figure 2 illustrating the multiple layers of the present invention.
FIG. 4 is a cross sectional view of an alternative embodiment of the present invention.
FIG. 5 is a block diagram illustrating the flexible low permeability tube fluidly connecting a thermal conditioning unit to a thermal management unit of a liquid thermal management system.

### DETAILED DESCRIPTION OF THE INVENTION

### A. Overview

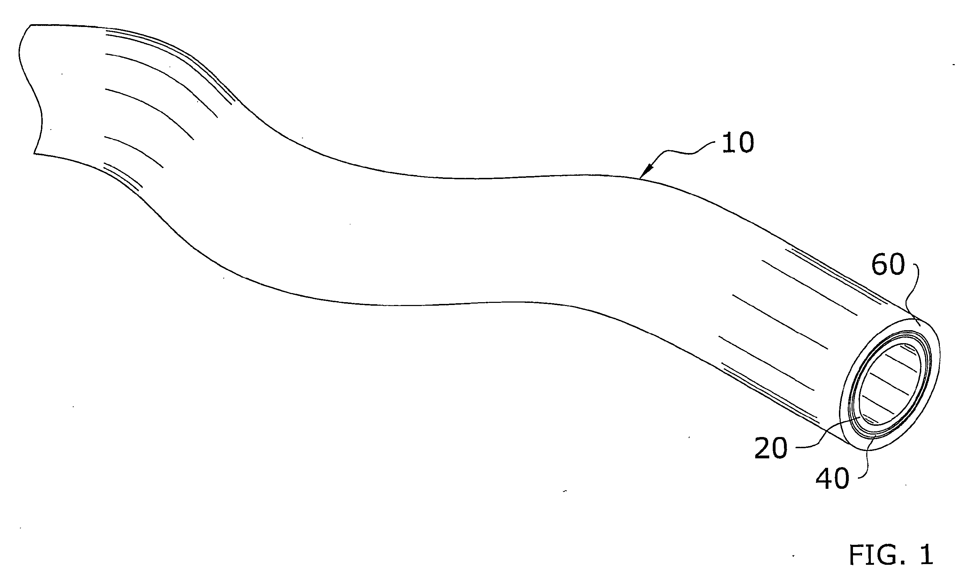

Turning now descriptively to the drawings, in which similar reference characters denote similar elements throughout the several views, FIGS. **1** through 5 illustrate a flexible low permeability hose **10,** which comprises a first layer **20** and a second layer **40** surrounding the first layer **20,** wherein a first adhesive **30** secures the second layer **40** to the first layer **20.** The first layer **20** is comprised of a material not adversely affected by coolants (e.g. perfluorocarbon fluids) such as but not limited to polyethylene. The second layer **40** is comprised of a material that is impermeable to coolants and gases (e.g. polyurethane material - ether based or ester based, or ethyl vinyl alcohol copolymer, a.k.a. EVOH) to prevent the escape of the coolant from the hose and to prevent the entry of air into the coolant through permeation. An additional third layer **60** may be secured about the second layer **40** with a second adhesive **50** to provide protection to the second layer **40** (e.g. fire protection, fluid exposure).

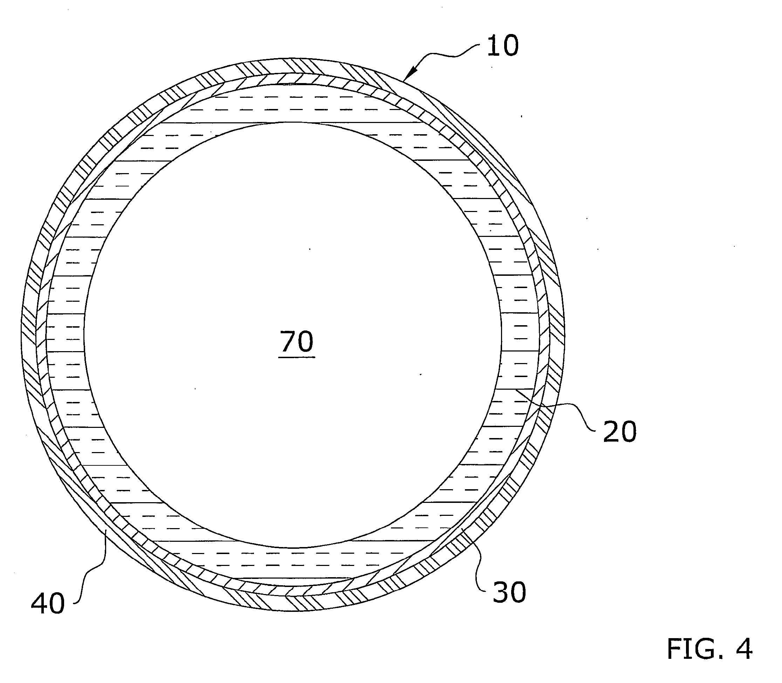

Figures 1 through 4 best illustrate the various embodiments of the flexible low permeability hose **10.** Figure 4 illustrates a cross sectional view of the preferred embodiment comprised of a first layer **20,** a second layer **40** surrounding the first layer **20** and a first adhesive **30** securing the second layer **40** to the first layer **20.** Figures 1 through 3 illustrate an alternative embodiment of the present invention where a third layer **60** is secured to the second layer 40 with a second adhesive **50.** The flexible low permeability hose **10** is preferably comprised of of a co-extruded hose structure. Both embodiments are discussed further herein.

### B. Flexible Low Permeability Hose - Preferred Embodiment

### i. First Layer

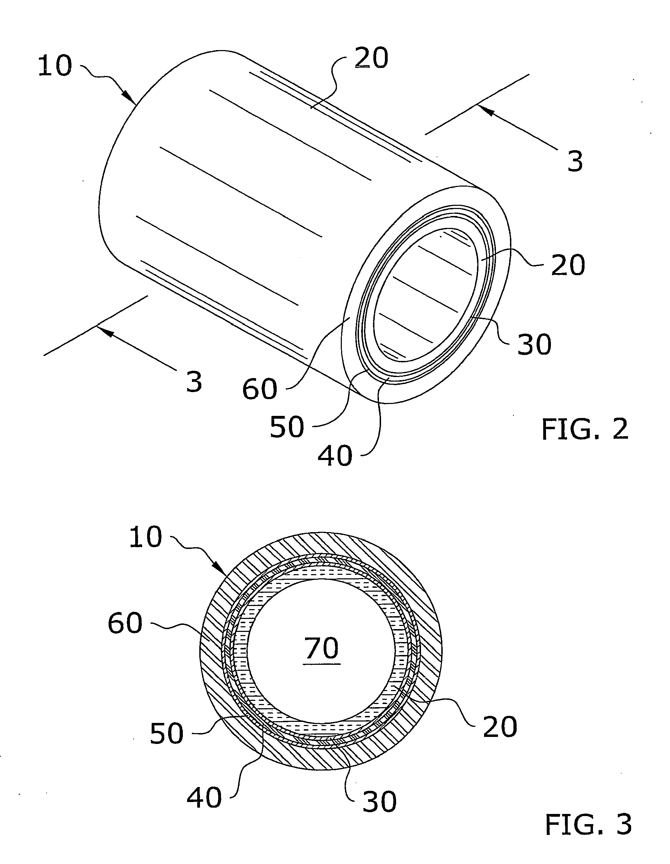

The first layer **20** defines the fluid passage **70** within the flexible low permeability tube **10** as shown in Figures 3 and 4 of the drawings. The fluid passage **70** is capable of transporting both liquids (liquid coolant) and/or gases (e.g. vaporized coolant). The fluid passage **70** may have various cross sectional shapes and may have various sizes capable of transferring a desired flowrate of coolant.

The first layer **20** of the flexible low permeability hose **10** is further comprised of a flexible material compatible with a coolant such as but not limited to a perfluorocarbon fluid (e.g. FLUORINERT manufactured by 3M). The first layer **20** is preferably comprised of a polyethylene material because of its desired fluid compatibility properties. It is further preferable that the first layer **20** is comprised of an ethylene-octene copolymer.

### ii. Second Layer

As shown in Figures 1 through 4 of the drawings, the second layer **40** of the flexible low permeability hose **10** surrounds the first layer **20.** The second layer **40** is comprised of a material that is impermeable to liquids and gases. It is preferable that the second layer **40** is impermeable to commonly utilized coolants in the electronics industry such as but not limited to perfluorocarbon fluids to prevent the escape of the coolant from the flexible low permeability hose **10.** It is further preferable that the second layer **40** is impermeable to gases such as but not limited to coolant vapor or air to prevent the escape of coolant and for preventing the entry of air into the coolant. The second layer may have a thickness fifty-percent or less than the first layer.

The second layer **40** is preferably comprised of a polyurethane material (ether based or ester based) because of its low gas and perfluorocarbon permeation. Alternatively, the second layer **40** may be comprised of an ethyl vinyl alcohol copolymer (a.k.a. EVOH).

One example of a desirable first layer **20** and second layer **40** combination is where the first layer **20** has a wall thickness of approximately 0.02 inches and wherein the second layer **40** has a wall thickness of approximately 0.03 inches.

### ii. First Adhesive

The first adhesive **30** secures the second layer **40** and the first layer **20** together as illustrated in Figures 2 through 4 of the drawings. The first adhesive **30** is preferably comprised of an adhesive resin that creates a strong, interlayer bond between the first layer **20** and the second layer **40.**

It is further preferable that the first adhesive **30** is comprised of a material that may be co-extruded or extrusion coated with the layers **20, 40.** The first adhesive **30** is preferably comprised of an ethyl vinyl acetate (EVA) such as the resin manufactured under the trademark ELVAX by DuPont which is incorporated by reference herein.

The thickness of the first adhesive **30** (and the second adhesive **50**) is preferably significantly less than the first layer **20** and the second layer **40.** In a preferred embodiment of the present invention, the first adhesive **30** (and the second adhesive **50** for the alternative embodiment) has a thickness of approximately 0.003 inches.

### C. Flexible Low Permeability Hose - Alternative Embodiment

Figures 1 through 3 illustrate a third layer **60** surrounding and secured to the second layer **40** by a second adhesive **50.** The second adhesive **50** is preferably comprised of the same material and thickness as the first adhesive **30** as discussed previously herein.

The third layer **60** is preferably comprised of a fire resistant material to protect the second layer **40** (and the first layer **20**) from damage. It is preferable that the third layer **60** is comprised of a material that may be co-extruded with the first layer **20** and the second layer **40.** The third layer **60** is preferably comprised of a polyethylene that includes a flame retardant manufactured under the trademark AMPSHIELD 1199 by Ampacet Corporation which is incorporated by reference herein. Additional layers may be added to the present invention.

### D. Liquid Thermal Management System

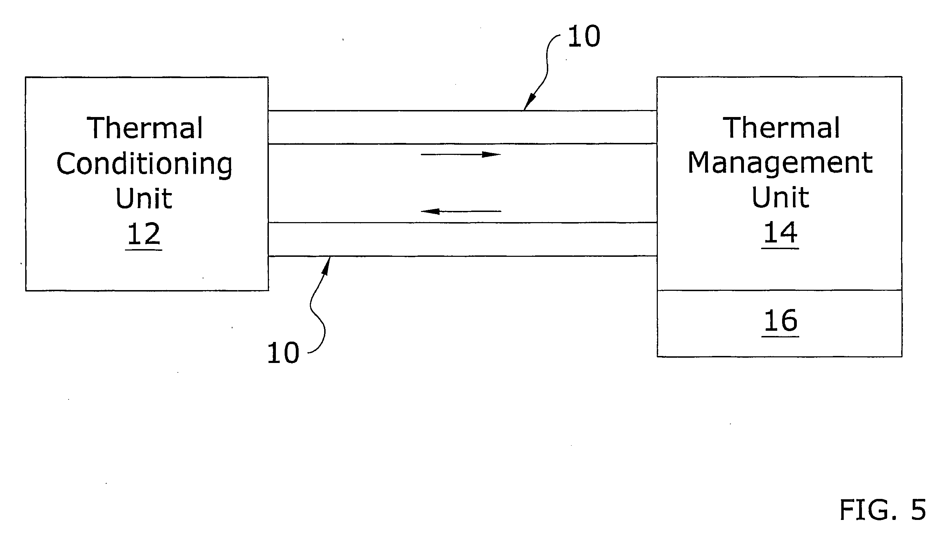

Figure 5 illustrates the exemplary usage of the flexible low permeability tube **10** within a liquid thermal management system for thermally managing a heat producing device **16** (e.g. microprocessor, electronic device). A thermal management unit **14** is fluidly connected to a first end of a flexible low permeability hose **10** as shown in Figure 5 of the drawings. The thermal management unit **14** is in thermal communication with the heat producing device **16** to thermally manage the heat producing device **16.**

The thermal management unit **14** may be comprised of a single-phase liquid thermal management system (e.g. liquid cold plates) or a multi-phase liquid thermal management system (e.g. spray cooling, pool boiling, flow boiling, jet impingement cooling, falling-film cooling, parallel forced convection, curved channel cooling and capillary pumped loops). Spray cooling technology is the preferred liquid thermal management system for use in the present invention. United States Patent No. 5,220,804 entitled High Heat Flux Evaporative Spray Cooling to Tilton et al. and United States Patent No. 6,108,201 entitled Fluid Control Apparatus and Method for Spray Cooling to Tilton et al. are hereby incorporated by reference herein.

A thermal conditioning unit **12** is fluidly connected to a second end of the flexible low permeability hose **10** as further shown in Figure 1 of the drawings. The thermal conditioning unit **12** thermally conditions the heated exhaust coolant received from the thermal management unit **14** to lower the temperature and return the coolant back to the thermal management unit **14** for thermally managing the heat producing device **16.** Figure 5 illustrates the usage of two flexible low permeability hoses **10** where one is a coolant supply line and a second is a coolant return line. The thermal conditioning unit **12** may include a heat exchanger, a pump, a filter and various other devices commonly utilized to thermally condition coolant.

What has been described and illustrated herein is a preferred embodiment of the invention along with some of its variations. The terms, descriptions and figures used herein are set forth by way of illustration only and are not meant as limitations. Those skilled in the art will recognize that many variations are possible within the spirit and scope of the invention, which is intended to be defined by the following claims (and their equivalents) in which all terms are meant in their broadest reasonable sense unless otherwise indicated. Any headings utilized within the description are for convenience only and have no legal or limiting effect.

## Claims

1. A flexible low permeability hose, comprising:
a first layer defining a fluid passage, wherein said first layer is comprised of a flexible material compatible with a coolant;
a second layer surrounding said first layer, wherein said second layer is comprised of a material that is impermeable to said coolant and external gases; and
a first adhesive securing said second layer to said first layer.

2. The flexible low permeability hose of Claim 1, wherein said first layer is comprised of a polyethylene material.

3. The flexible low permeability hose of Claim 1, wherein said first layer is comprised of an ethylene-octene copolymer.

4. The flexible low permeability hose of Claim 1, wherein said coolant is comprised of a perfluorocarbon fluid.

5. The flexible low permeability hose of Claim 1, wherein said first layer has a thickness of approximately 0.02 inches and wherein said second layer has a thickness of approximately 0.03 inches.

6. The flexible low permeability hose of Claim 1, wherein said second layer is comprised of an ether based polyurethane or an ester based polyurethane.

7. The flexible low permeability hose of Claim 1, wherein said first layer, said second layer and said first adhesive are comprised of a co-extruded structure.

8. The flexible low permeability hose of Claim 1, including a third layer surrounding and secured to said second layer by a second adhesive.

9. The flexible low permeability hose of Claim 8, wherein said third layer is comprised of a fire resistant material.

10. A liquid thermal management system for thermally managing a heat producing device, comprising:
a flexible low permeability hose comprised of:
a first layer defining a fluid passage, wherein said first layer is comprised of a flexible material compatible with a coolant;
a second layer surrounding said first layer, wherein said second layer is comprised of a material that is impermeable to said coolant and external gases; and
a first adhesive securing said second layer to said first layer;
a thermal management unit fluidly connected to a first end of said flexible low permeability hose;
a heat producing device in thermal communication with said thermal management unit; and
a thermal conditioning unit fluidly connected to a second end of said flexible low permeability hose, wherein said thermal conditioning unit thermally conditions exhaust coolant received from said thermal management unit.

11. The flexible low permeability hose of Claim 10, wherein said first layer is comprised of a polyethylene material.

12. The flexible low permeability hose of Claim 10, wherein said first layer is comprised of an ethylene-octene copolymer.

13. The flexible low permeability hose of Claim 10, wherein said coolant is comprised of a perfluorocarbon fluid.

14. The flexible low permeability hose of Claim 11, wherein said first layer has a thickness of approximately 0.02 inches and wherein said second layer has a thickness of approximately 0.03 inches.

15. The flexible low permeability hose of Claim 11, wherein said second layer is comprised of an ether based polyurethane or an ester based polyurethane.

16. The flexible low permeability hose of Claim 11, wherein said first layer, said second layer and said first adhesive are comprised of a co-extruded structure.

17. The flexible low permeability hose of Claim 11, including a third layer surrounding and secured to said second layer by a second adhesive, wherein said third layer is comprised of a fire resistant and abrasion resistant material.

18. A liquid thermal management system for thermally managing a heat producing device, comprising:
a flexible low permeability hose comprised of:
a first layer defining a fluid passage, wherein said first layer is comprised of a flexible material compatible with a coolant;
wherein said first layer is comprised of a polyethylene material;
a second layer surrounding said first layer, wherein said second layer is comprised of a material that is impermeable to said coolant and external gases;
wherein said second layer is comprised of an ether based polyurethane or an ester based polyurethane;
wherein said first layer, said second layer and said first adhesive are comprised of a co-extruded structure;
wherein said second layer has a thickness fifty-percent or less than said first layer; and
a first adhesive securing said second layer to said first layer;
a thermal management unit fluidly connected to a first end of said flexible low permeability hose;
a heat producing device in thermal communication with said thermal management unit; and
a thermal conditioning unit fluidly connected to a second end of said flexible low permeability hose, wherein said thermal conditioning unit thermally conditions exhaust coolant received from said thermal management unit;

19. The flexible low permeability hose of Claim 18, wherein said first layer is comprised of an ethylene-octene copolymer.

20. The flexible low permeability hose of Claim 18, wherein said coolant is comprised of a perfluorocarbon fluid.

21. The flexible low permeability hose of Claim 18, wherein said first layer has a thickness of approximately 0.02 inches and wherein said second layer has a thickness of approximately 0.03 inches.

22. The flexible low permeability hose of Claim 18, including a third layer surrounding and secured to said second layer by a second adhesive, wherein said third layer is comprised of a fire resistant and abrasion resistant material.
